Europäisches Patentamt

European Patent Office

Office européen des brevets

(11) Veröffentlichungsnummer: **0 259 614 B1**

(19)

(12) **EUROPÄISCHE PATENTSCHRIFT**

(45) Veröffentlichungstag der Patentschrift: **22.01.92**

(21) Anmeldenummer: **87111361.9**

(22) Anmeldetag: **06.08.87**

(51) Int. Cl.⁵: **G11C 11/24**, G11C 23/00, G11C 17/04, G11C 17/02

(54) **Speicher für digitale elektronische Signale.**

(30) Priorität: **10.09.86 CH 3647/86**

(43) Veröffentlichungstag der Anmeldung:
**16.03.88 Patentblatt 88/11**

(45) Bekanntmachung des Hinweises auf die
Patenterteilung:
**22.01.92 Patentblatt 92/04**

(84) Benannte Vertragsstaaten:
**AT CH DE FR GB GR IT LI NL SE**

(56) Entgegenhaltungen:
**EP-A- 0 046 873**
**WO-A-86/03879**
**FR-A- 2 357 023**
**FR-A- 2 376 549**

**IBM TECHNICAL DISCLOSURE BULLETIN,
Band 20, Nr. 12, Mai 1978, Seite 5309, New
York, US; K.E. PETERSEN: "Bistable micromechanical storage element in silicon"**

**R.C.A. REVIEW, Band 34, März 1973, Seiten
45-79, Princeton, US; L.S. COSENTINO et al.:
"A membrane page composer"**

**IBM JOURNAL OF RESEARCH AND DEVE-
LOPMENT, Band 23, Nr. 4, Juli 1979, Seiten
376-385, IBM Corp., New York, US; K.E. PE-
TERSEN: "Micromechanical membrane switches on silicon"**

(73) Patentinhaber: **Landis & Gyr Betriebs AG**

**CH-6301 Zug(CH)**

(72) Erfinder: **Radivoje, Popovic**
**Fridbach 1**
**CH-6300 Zug(CH)**
Erfinder: **Katalin, Solt**
**Hofstrasse 45**
**CH-6300 Zug(CH)**
Erfinder: **Heinz, Lienhard**
**Rosenbergweg 14**
**CH-6300 Zug(CH)**

(74) Vertreter: **Müller, Hans-Jürgen, Dipl.-Ing. et al
Müller, Schupfner & Gauger Maximilianstrasse 6 Postfach 10 11 61
W-8000 München 1(DE)**

EP 0 259 614 B1

**Beschreibung**

Die Erfindung bezieht sich auf einen Speicher für digitale elektronische Signale mit unverlierbarem Gedächtnis der im Oberbegriff des Anspruchs 1 angegebenen Art. Solche Speicher mit während des Betriebes elektrisch setz- und rückstellbaren Speicherelementen werden in elektronischen Geräten zum Speichern von Informationen auch über Gerätestillstandszeiten hinaus benötigt.

Speicherelemente dieser Art sind seit einiger Zeit bekannt z.B. in Form von Ferritringen im Ringkernspeicher, in Form von magnetischen Domänen im Magnetblasenspeicher, in Form bistabiler Multivibratoren in einem Random Access Memory (RAM) mit Pufferbatterie zur Ueberbrückung von Speisespannungsausfällen oder in Form von im Betrieb aufladbaren und entladbaren Kondensatoren in einem "Electrically Erasable Programmable Read Only Memory" (EEPROM). Eine Weiterentwicklung der bis anhin umständlich ansteuerbaren EEPROM's wird in ELECTRONICS WEEK vom 11. März 85 auf den Seiten 69 ff beschrieben. Aus der Erkenntnis, dass ein unverlierbares Gedächtnis dieser Art in den meisten Anwendungsfällen nur einige 1000 Speicherelemente aufweisen muss, konnte auf Halbleitersubstrat neben den Speicherelementen, der Ansteuerung und der Ausleseschaltung auch die Erzeugungsvorrichtung der wesentlich über der Speisespannung (+ 5 V) liegenden Spannung von 25 V zum Verändern des Informationsinhalts untergebracht werden.

Eine Beschreibung der Elemente und der Organisation von Halbleiterspeichern allgemein gibt z.B. McCarty in "MOS Device and Circuit Design", Wiley 1983, ISBN 0 471 10026 9.

Speicherelemente der genannten Art haben den Nachteil, dass sie wie die Ferritkernspeicher und Magnetblasenspeicher nicht mit der gleichen Technologie wie die Ansteuerschaltungen hergestellt werden können und daher langsam und teuer sind, oder dass sie wie die Halbleiterspeicher die Information nur für eine beschränkte Zeit halten, z. B. bis beim RAM die Batterie erschöpft oder bis die Ladung aus dem Kondensator einer EEPROM-Speicherzelle z. B. unter dem Einfluss ionisierender Strahlung abgeflossen ist. Die EEPROM-Speicherzelle hat zudem mit $10^4$ bis $10^6$ eine sehr beschränkte Zahl von Schreibzyklen.

Auf den Halbleitersubstraten aus z. B. Silizium lassen sich mikromechanische Geräte und insbesondere elektrische Schalter von mikroskopischen Abmessungen aufbauen mit denselben Fabrikationsschritten wie Diffusion, Oxydation, Abscheiden dünner Schichten, Maskieren mit photolithographischen Mitteln und Aetzen, wie sie bei der Herstellung elektronischer Elemente in integrierten Schaltungen vorkommen. Der Stand der Technik ist in US-PS 4.570.139 und den dort zitierten Veröffentlichungen dargelegt.

Bistabile mikromechanische Speicherelemente des Membrantyps sind aus der IBM Technical Disclosure Bulletin Vol. 20, No. 12, Mai 1978, Seite 5309 bekannt. Dabei überbrückt eine mit einer Metallschicht überzogene, beidseitig eingespannte bistabile Oxidmembran eine Vertiefung auf einem p-leitenden Substrat. Die Membran biegt sich in eine der beiden stabilen Endlagen durch. Die Membran kann aus der einen stabilen Lage durch elektrostatische Anziehungskräfte in die andere stabile Lage umgelegt werden. Dabei werden elektrische Spannungen beliebiger Polarität zwischen der Metallschicht und dem Substrat bzw. einer oberhalb der Membran angeordneten Elektrode zur Wirkung gebracht. Diese Speicherelemente können gemäß dem IBM J. Res. Develop., Vol. 23, No. 4, Juli 1979, Seiten 376 bis 385, hergestellt werden.

Darüber hinaus sind auch elektrostatisch auslenkbare Membranen zur optischen Anzeige bekannt (FR-A-2 357 023), bei denen der Boden einer in einem Substrat ausgebildeten Vertiefung mit einer Elektrode bedeckt ist, während die Vertiefung durch eine monostabile elastische Membrane abgedeckt wird, welche durch elektrostatische Anziehungskräfte stetig deformierbar ist, wobei die Membran in die Vertiefung gezogen wird. Zwei definierte unterschiedliche stabile Lagezustände sind hierbei jedoch nicht einstellbar.

Der Erfindung liegt die Aufgabe zugrunde, einen elektronisch beschreibbaren und auslesbaren Speicher der eingangs genannten Art zu schaffen, dessen Inhalt auch über lange Zeit trotz äußerer Einwirkungen wie ionisierenden Strahlung unverlierbar ist und dessen Abmessungen und Technologie sich für eine Integration mit Transistoren auf einem Halbleitersubstrat eignen.

Die Lösung dieser Aufgabe gelingt durch die im Anspruch 1 angegebenen Merkmale.

Nachfolgend werden Ausführungsbeispiele der Erfindung anhand der Zeichnung näher beschrieben.

Es zeigen:

Figur 1    den prinzipiellen Aufbau eines Speicherelementes mit den beiden Lagezuständen einer Membrane im Schnitt,

Figur 2    den prinzipiellen Schichtaufbau im Bereich eines Speicherelementes vor dem Aetzen im Schnitt,

Figur 3    eine Ansicht einer Anordnung von Membranen über einer Vertiefung,

Figur 4    eine Ausführung einer Speicherzelle mit einer Auslesevorrichtung,

Figur 5    ein Diagramm des zeitlichen Ablaufs von Schreibzyklen,

Figur 6    einen Schnitt durch das Speicherelement gemäss der Fig. 1 jedoch mit elektromagnetischer Umstellung der Membrane,

Figur 7    ein Diagramm des zeitlichen Ablaufs von Lesezyklen und

Figur 8    eine Ausführung der Speicherzelle mit einer anderen Auslesevorrichtung.

Gemäss der Lehre in "Silicon as a Mechanical Material" von K.E. Petersen in Proceedings of the IEEE, Vol 70, No. 5, May 1982 lassen sich mikromechanische und elektronische Bauelemente auf einem Halbleitersubstrat mit gleichen oder verwandten Verfahren herstellen. Eine Integration von mindestens einem dieser erfindungsgemässen Speicherelemente mit der zugehörigen Elektronik auf einem Substrat ermöglicht wegen der Kleinheit des Speicherelementes, der geringen Leistungsaufnahme und der für die Massenfabrikation geeigneten Verfahren besonders vorteilhafte Ausführungen der Erfindung.

Denkbar sind auch Ausführungen in vergrösserten Formen und konventioneller Technik.

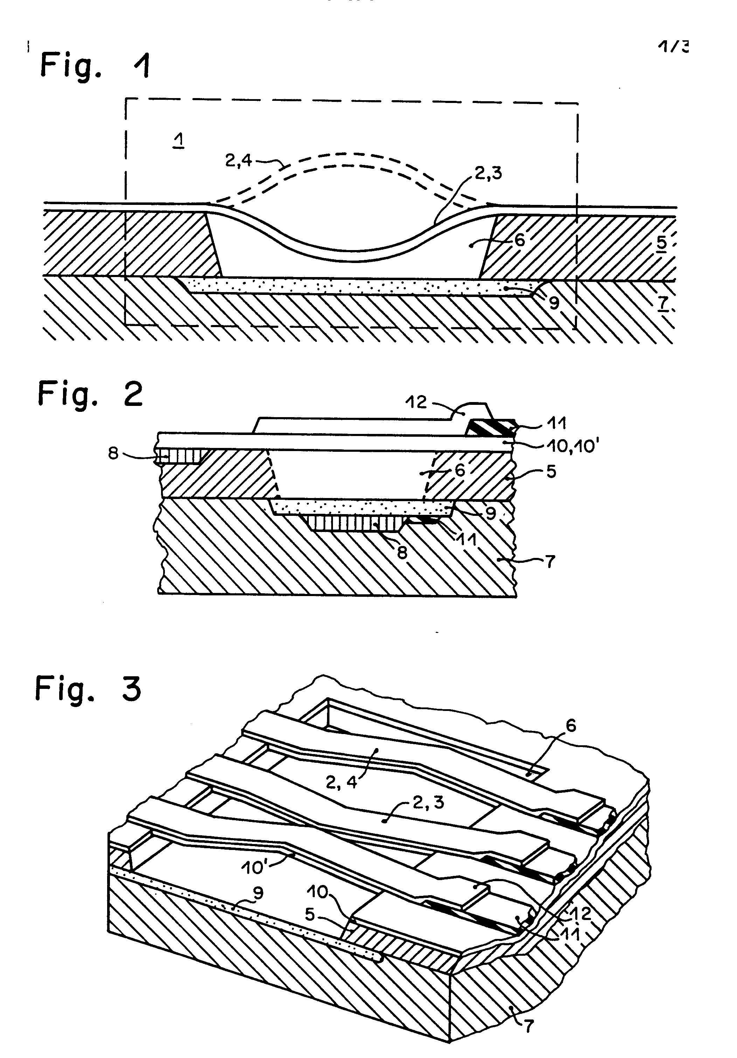

Ein Speicherelement 1 besteht gemäss der Figur 1 aus einer unter mechanischer Spannung verformten brückenförmigen Membrane 2, die zwei stabile Lagezustände 3 und 4 aufweist, einem Stützer 5 und einer Vertiefung 6 auf der Oberfläche einer vorteilhaft schwach p-leitenden Silizium (Si)-Einkristallscheibe, die im folgenden Substrat 7 genannt ist.

Die Herstellung des Speicherelementes 1 folgt zunächst dem Stand der Technik gemäss dem zitierten Aufsatz von Petersen. Für die Erzeugung der brückenförmigen Membrane 2 muss auf dem Substrat 7 örtlich durch photolithographische Masken begrenzt eine geeignete Folge von Schichten (Figur 2) aufgebaut werden, damit die gewünschten mechanischen Elemente im letzten Verfahrensschritt durch Aetzen freigelegt werden können:

-    Erzeugung allfälliger elektronischer Elemente 8, die unter der Membrane 2 angeordnet sind, und deren Verbindungsleitungen.

-    Auf dem Substrat 7 wird eine Sperrschicht 9 im Gebiet der Vertiefung 6 erzeugt, die den Materialabtrag beim Aetzen in die Tiefe begrenzt. Je nach Anwendungszweck kann eine gut leitende $p^{+}$-Si-Schicht durch Eindiffundieren von Bor in die Substratoberfläche oder durch Oxydation der Substratoberfläche ein Ueberzug aus $SiO_2$ (Isolator) z.B. als Abdeckung von elektronischen Elementen 8 oder Leiterbahnen 11 erzeugt werden.

-    Ueber diese Sperrschicht 9 wird eine schwachleitende p-Si-Schicht aufgebaut, deren Dicke die Höhe der Stützer 5 bestimmt.

-    Ausserhalb der Gebiete mit darunterliegender Sperrschicht 9 können z. B. elektronische Elemente 8 und dazugehörige Leiterbahnen angelegt werden.

-    Ueber diese Schicht für die Stützer 5 wird durch Oxydation der Oberfläche eine Isolatorschicht 10 erzeugt. Sie bildet eine Basisschicht 10′ für die Membranen 2.

-    Aufbringen der notwendigen metallischen Leiterbahnen 11, z. B. aus Au, Cr, Al usw.

-    In einem zusätzlichen, neuen Herstellungsschritt wird bei Temperaturen des Substrates 7 im Bereich des siedenden Stickstoffs auf den Membranen 2 eine Metallschicht 12 abgelagert, z. B. 20 bis 100 nm dick. Die Metallschicht 12 kann aus einer oder mehreren Schichten, aus verschiedenen Metallen oder Legierungen aufgebaut sein, z. B. aus Al, Cr Au, Fe usw.

-    In den nachfolgenden Herstellungschritten gemäss dem Stand der Technik werden die Membranen 2 freigeätzt.

-    Die betriebsbereiten elektronisch-mikromechanischen Schaltungen werden wie normale IC-Schaltungen geprüft und z. B. in die standardisierten IC-Gehäuse verpackt.

Die grossen Unterschiede der thermischen Längenausdehnungskoeffizienten der im neuen Herstellungsschritt aufgebrachten Metallschicht 12 und der Basisschicht 10′ aus $SiO_2$ verstärken die in der Basisschicht 10′ vorhandenen, in Längsrichtung der Membranen 2 wirkenden Kompressionsspannungen derart, dass sich die brückenförmige Membrane 2 nach dem Freiätzen über der Vertiefung 6 in einem stabilen Lagezustand 3, 4 nach oben oder nach unten durchwölbt (Figur 1). In der Figur 3 ist ein Ausführungsbeispiel mit den gleichen Bezugsnummern für gleiche Element wie in den Figuren 1 und 2 dargestellt. Damit eine Membrane 2 von einem Lagezustand 3 bzw. 4 in den andern Lagezustand 4 bzw. 3 gebracht werden kann, muss eine von den Kompressionsspannungen erzeugte mechanische Federkraft überwunden werden, bis die Membrane 2 unter der eigenen Federkraft in den andern Lagezustand 3, 4 kippt. Die Umkippzeit der Membrane 2 ist von deren Abmessungen abhängig. Dieses mechanisch bistabile Verhalten der Membrane 2 wird zum Speichern der Information ausgenützt, wobei den Lagezuständen 3, 4 die beiden logischen Zustände "0" und "1" zugeordnet sind.

Die Abmessungen der Membranen 2 hängen von den Fortschritten der IC-Technologie ab. Ein typisches Ausführungsbeispeil in der heute üblichen Technologie mit 2 $\mu$m Linienbreite weist eine Membrane 2 mit den Abmessungen von 10 $\mu$m Länge, 2 $\mu$m Breite und 0,1 $\mu$m Dicke auf. Die Durchbiegung der Membrane 2 beträgt etwa 0,1 $\mu$m in jeder der beiden Lagezustände 3, 4. Die Höhe der Stützer 5 misst 0,2 $\mu$m. Die Umkippzeit beträgt einige Mikrosekunden.

Die geringe Masse der Membrane 2 von einigen ng verhindert ein mechanisches Umschalten der Membrane 2 durch Beschleunigungskräfte.

Andere Ausführungen des Speicherelelemtes 1 zeichnen sich durch folgende Merkmale aus:

- Die Membrane 2 besteht lediglich aus der aus mindestens einem Metall oder mindestens einer Metallegierung gebildeten Metallschicht 12.
- Mehrere voneinander unabhängige Membranen 2 auf dem gleichen Substrat 7 ermöglichen, entsprechend mehr Information zu speichern, und
- mehrere Membranen 2 überbrücken parallel die gleiche Vertiefung 6.

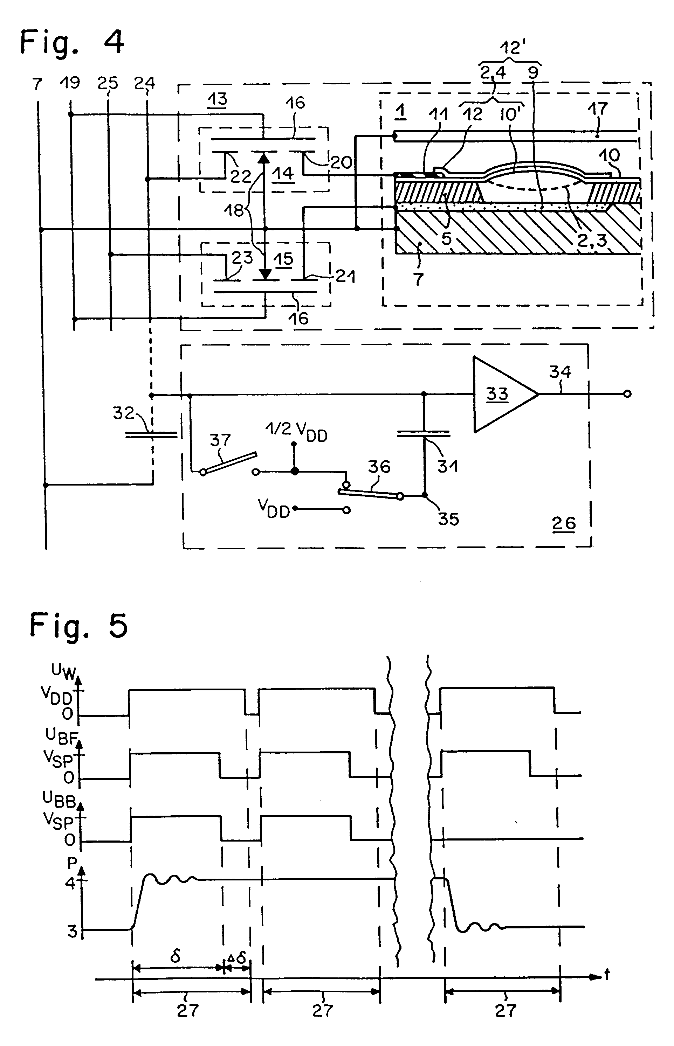

Die Kräfte zum Umstellen der Membrane 2 von der einen in die andere stabile Lage liefern vorteilhaft elektrostatische oder elektromagnetische Felder. In einer mit geringem Energieverbrauch ausgezeichneten Ausführungsform besteht die Sperrschicht 9 auf dem Substrat 7 aus elektrisch gut leitendem Material, z. B. $p^+$-Si (Figur 4). Die Membrane 2 mit der Metallschicht 12 und die Sperrschicht 9 bilden einen Plattenkondensator 12', dessen Kapazitätswert von den Membrandimensionen, der Höhe der Stützer 5 und dem Lagezustand 3, 4 der Membrane 2 bestimmt ist. Eine Ansteuerung der Kondensatorplatten zeigt beispielhaft die Figur 4. Eine Speicherzelle 13 besteht aus zwei Feldeffekt-Transistoren 14, 15 mit isoliertem Gate 16 (MOSFET) und dein im Schnitt dargestellten Speicherelement 1. Eine andere Ausführungsform der Speicherzelle 13 zeichnet sich durch eine zusätzliche, die Speicherzelle 13 abdeckende Abschirmung 17 aus. Die Abschirmung 17 überdeckt im Abstand von z. B. 0,1 bis 1 mm alle auf dem gleichen Substrat 7 befindlichen Speicherelemente 1 und ist mit dem aus dem Substrat 7 und den Substraten 18 der MOSFET 14, 15 jeder Speicherzelle 13 gebildeten Bezugspotential aller elektrisch relevanten Spannungen auf dem Substrat 7 leitend verbunden.

Eine WORD (W)-Leitung 19 verbindet jedes GATE 16 der MOSFET 14, 15 einer Speicherzelle 13 sowie die GATE 16 der entsprechenden MOSFET 14, 15 aus allfällig weiteren Speicherzellen 13. Der Strom durch die MOSFET 14, 15, d. h. zwischen Kontakten 20, 22 und Kontakte 21 und 23, ist mittels des Potentials des GATE 16 gesteuert.

Der Kontakt 20 des MOSFET 14 ist mit der Membrane 2 bzw. der Metallschicht 12 elektrisch verbunden. Der andere Kontakt 22 des MOSFET 14 ist über eine BIT BRIDGE (BB)-Leitung 24 mit Kontakten 22 der MOSFET 14 allfällig anderer Speicherzellen 13 verbunden.

Der Kontakt 21 des MOSFET 15 ist mit der Sperrschicht 9 des Speicherelementes 1 elektrisch verbunden. Eine BIT FORCE (BF)-Leitung 25 verbindet Kontakte 23 der MOSFET 15 der Speicherzellen 13. Der Flächenbedarf einer Speicherzelle 13 beträgt etwa das Zehnfache eines Speicherelementes eines modernen Dynamic Random Access Memory-Bausteins.

Die W-Leitung 19, die BB-Leitung 24 und die BF-Leitung 25 stehen mit elektronischen Mitteln, die vorzugsweise auf demselben Substrat 7 untergebracht sind, in Verbindung. Diese Mittel ermöglichen in jeder Speicherzelle 13 oie Membrane 2 in eine der beiden stabilen Lagezustände 3, 4 zu bringen und die Stellung der Membrane 2 jeder Speicherzelle 13 abzufragen. In Figur 4 ist beispielhaft eine Auslesevorrichtung 26 zum Abfragen des Lagezustandes 3, 4 mittels Messen des Kapazitätswertes des Plattenkondensators 12' einer Speicherzelle 13 gezeigt.

Zum Einschreiben der Information in eine Speicherzelle 13 wird die W-Leitung 19 auf ein Potential $V_{DD}$ - (z. B. + 5 V) gebracht.

Soll die Membrane 2 in den Lagezustand 4 gebracht oder belassen werden, erhalten die BB-Leitung 24 und die BF-Leitung 25 während einer Dauer $\delta$ von z. B. zehn Eigenschwingungen der Membrane 2 ein Potential $V_{SP}$ (z. B. + 10 bis + 20 V). Da beide MOSFET 14, 15 elektrisch leitend sind, fliesst eine elektrische Ladung in den aus der Metallschicht 12 und der Umgebung (z. B. Abschirmung 17) gebildeten Kondensator und in den aus der Sperrschicht 9 und dem Substrat 7 gebildeten Kondensator. Die gleichnamige Ladung in der Sperrschicht 9 und der Metallschicht 12 erzeugen eine zwischen den beiden Schichten 9, 12 wirkende, abstossende Kraft. Falls die Membrane 2 sich im Lagezustand 3 befindet, werden die in der Membrane 2 wirkenden mechanischen Kräfte überwunden, und die Membrane 2 schnappt in den Lagezustand 4. Das Potential $V_{SP}$ muss während der Dauer $\delta$ auf den Leitungen 24, 25 beibehalten werden, bis die Eigenschwingungen der Membrane 2 sicher abgeklungen sind. Danach werden die BB-und die BF-Leitungen 24, 25 auf das Bezugspotential gelegt und die elektrischen Ladungen aus dem Speicherelement 1 entfernt. Anschliessend kann die W-Leitung 19 auf das Bezugspotential gelegt werden, d. h. die MOSFET 14, 15 isolieren das Speicherelement 1 von den elektr. Zuführungen 24, 15.

Soll die Membrane 2 in den Lagezustand 3 gebracht oder belassen werden, wird das Potential $V_{DD}$ auf die W-Leitung 19 gelegt und die BB-Leitung 24 wird auf dem Bezugspotential gehalten. Die BF-Leitung 25 erhält während der Dauer $\delta$ das Potential $V_{SP}$, und der Plattenkondensator 12' wird aufgeladen. Die daher auf die Membrane 2 einwirkenden Kräfte überwinden die die Membrane 2 in dem Lagezustand 4 haltenden, mechanischen Kräfte, und die Membrane 2 schnappt in der Lagezustand 3. Nach dem Entladen der Sperrschicht 9 über die BF-Leitung 25 auf das Bezugspotential wird die W-Leitung 19 ebenfalls auf das Bezugspotential gelegt, damit das Speicherelement 1 wieder elektrisch isoliert ist.

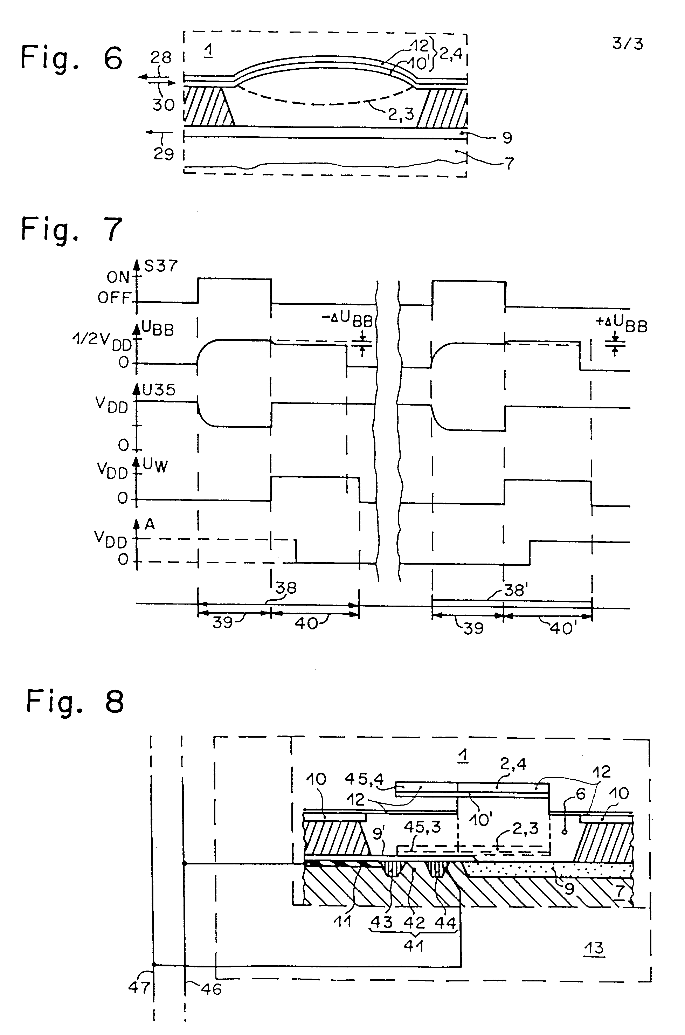

Der zeitliche Ablauf der beiden Einschreibvorgänge ist in der Figur 5 graphisch dargestellt. Es bedeuten eine Funktion $U_W$ das Potential der W-Leitung 19, eine Funktion $U_{BF}$ das Potential der BF-Leitung 25 und eine Funktion $U_{BB}$ das Potential der BB-Leitung in Abhängigkeit von der Zeit t. Für das Erreichen des Lagezustandes 4 weisen $U_{BF}$ und $U_{BB}$, für das Erreichen des Lagezustandes 3 nur $U_{BF}$ während der Dauer $\delta$ das Potential $V_{SP}$ auf, während die W-Leitung 19 mit der für das Entladen zusätzlich notwendigen Zeit $\Delta\,\delta$ auf dem Potential $V_{DD}$ liegt. Ein Schreibzyklus 27 setzt sich daher aus den Zeiten $\delta$ und $\Delta\,\delta$ zusammen. Eine Funktion P zeigt symbolisch die Lage der Membrane 2 an, die zwischen den beiden Lagezuständen 3, 4 umgestellt wird. In der Figur 5 folgen sich als Beispeil zwei Schreibzyklen 27 für den Lagezustand 4 hintereinander, später folgt ein Schreibzyklus 27 für den Lagezustand 3.

In einer anderen Ausführungsform des Speicherelementes lassen sich auch elektromagnetische Kräfte zum Umsetzen der Membrane 2 vom einen Lagezustand in den anderen einsetzen. Die Sperrschicht 9 und die Metallschicht 12 sind in der Figur 6 als parallel geführte Leiter ausgebildet. Elektronische, auf dem Substrat 7 vorzugsweise integrierte Mittel geben während der Dauer $\delta$ des Schreibzyklus einen Strom 28 in der Metallschicht 12 und einen Strom 29 in der Sperrschicht 9 frei. Einer der beiden Ströme 28, 29 lässt sich mittels dieser elektronischen Mittel in der Richtung umsteuern, z. B. anstelle des Stromes 28 fliesst in entgegengesetzter Richtung ein Strom 30. Fliessen die Ströme 29, 30, d. h. in entgegengesetzter Richtung zueinander, wird die Membrane 2 durch die elektromagnetischen Kräfte in den Lagezustand 4 gedrückt; fliessen jedoch die Ströme 28, 29, d. h. parallel zueinander, wird durch die elektromagnetischen Kräfte die Membrane 2 in den Lagezustand 3 gebracht.

Die elektrisch gut leitende Sperrschicht 9 kann auch durch eine isolierende Sperrschicht aus $SiO_2$ mit einer darunter liegenden gut leitenden Leiterbahn 11 ersetzt werden, wenn dies die Zahl der Herstellungsschritte reduziert.

Das Auslesen der von der Membrane 2 in Form des Lagezustandes 3, 4 gespeicherten Information kann z. B. durch die nachfolgend aufgeführten Ausführungsbeispiele erfolgen.

1) Die Auslesevorrichtung 26 kann die Unterschiede der Kapazitätswerte des Plattenkondensators 12' für die beiden Lagezustände 3, 4 der Membrane 2 feststellen. C3 ist der Kapazitätswert für den Lagezustand 3 und C4 der um etwa einen Faktor 2 kleinere Kapazitätswert für den Lagezustand 4. Ein Messkondensator 31 weist die Kapazität

$$CD = \frac{C3 + C4}{2} \qquad\qquad (1)$$

auf. Die BB-Leitung 24 mit einer gegen das Bezugspotential gemessenen Streukapazität 32 mit dem Wert CS übernimmt die Funktion einer Abtastleitung und endet am Eingang eines SENSE-Verstärkers 33. Am Ausgang 34 des SENSE-Verstärkers 33 erscheint beim Auslesen die Information in der für die Weiterverarbeitung geeigneten Form. Der Eingang des SENSE-Verstärkers 33 ist mit dem einen Belag des Messkondensators 31 verbunden. Der andere Belag des Messkondensators 31 ist mit einem Punkt 35 eines Umschalters 36 verbunden. Je nach Stellung des Umschalters 36 ist der Punkt 35 auf das Potential $V_{DD}$ oder 1/2 $V_{DD}$ gelegt. Die BB- Leitung 24 ist mit dem einen Anschluss eines Schalters 37 verbunden; der andere Anschluss des Schalters 37 liegt auf dem Potential 1/2 $V_{DD}$` Die Schalte 36, 37 sind vorteilhaft auf dem Substrat 7 als Transistoren integriert.

In der Figur 7 ist der zeitliche Ablauf eines Lesezyklus 38 aufgezeichnet. Die Elemente 19, 24, 25 und 31 bis 37 sind in der Figur 4 dargestellt und in der Beschreibung für die Figur 7 mit gleichen Bezugsnummern verwendet.

Während des ganzen Lesezyklus 38 wird die BF-Leitung 25 auf das Bezugspotential gelegt. Der Lesezyklus 38 besteht aus einer PRECHARGE-Phase 39 und einer SENSE-Phase 40. Eine Funktion S37 zeigt die Stellung des Schalters 37, die Funktion $U_{BB}$ das Potential der BB-Leitung 24, eine Funktion U35 das Potential in Punkt 35, die Funktion $U_W$ das Potential der W-Leitung 19 und eine Funktion A das Signal am Ausgang 34.

Der Lesezyklus 38 beginnt mit der PRECHARGE-Phase 39. Ueber den zu Beginn der PRECHARGE-Phase 39 geschlossenen Schalter 37 wird die BB-Leitung 24 mit der Streukapazität 32 auf $U_{BB}$ = 1/2 $V_{DD}$ aufgeladen. Gleichzeitig wird der Kondensator 31 über den Umschalter 36 entladen. Die PRECHARGE-Phase endet mit dem Ausschalten des Schalters 37 und dem Umschalten des Punktes 35 auf das Potential $V_{DD}$. Zu Beginn der SENSE-Phase 40 fliesst aus dein Kondensator 31 eine Ladung

EP 0 259 614 B1

$$Q31 \simeq 1/2\ V_{DD} \cdot CD \qquad (2)$$

auf die BB-Leitung 24. Da gleichzeitig das Potential $U_w$ auf den Wert $V_{DD}$ ansteigt, leiten die MOSFET 14, 15 (Figur 4) je nach Lagezustand 3, 4 eine Ladung

$$Q3 \simeq 1/2\ V_{DD} \cdot C3$$

oder

$$Q4 \simeq 1/2\ V_{DD} \cdot C4 \qquad (3)$$

in den Plattenkondensator 12' ab.

Die Gleichungen 2 und 3 gelten nur unter der Voraussetzung, dass der Wert CS der Streukapazität 32 viel grösser ist als die Summe der Kapazitäten C3 + C4 + CD. Die Aenderung $\Delta U_{BB}$ des Potential $U_{BB}$ - (Figur 7) beträgt am Eingang des SENSE-Verstärkers 33 unter Berücksichtigung der Gleichungen 1 bis 3 für den Lagezustand 3

$$\Delta U_{BB} = -\ 1/2 \cdot V_{DD} (C3 - C4) / CS \qquad (4)$$

und für den Lagezustand 4

$$\Delta U_{BB} = 1/2\ V_{DD} (C3 - C4) / CS. \qquad (5)$$

Das Verhältnis (C3 - C4) / CS beträgt z. B. etwa 0,02 und $\Delta U_{BB}$ daher etwa $0,01 \cdot V_{DD}$. Nach McCarty können bekannte SENSE-Verstärker 33 diese Spannungsdifferenzen zuverlässig feststellen und das dem Zustand des Speicherelementes 1 entsprechende Signal A am Ausgang 34 erzeugen. Die SENSE-Phase 40 endet mit dem Absenken von $U_{BB}$ auf das Bezugspotential, und nach einer Wartezeit zum Entladen des Plattenkondensators 12' wird auch die W-Leitung 19 auf das Bezugspotential gelegt und so die Sperrschicht 8 und die Metallschicht 12 von den Leitungen 24, 25 isoliert.

In der Figur 7 wird als Beispiel im Lesezyklus 38 ein Speicherelement 1 mit der Membrane 2 im Lagezustand 3 ausgelesen. Der im Vergleich zu CD grössere Kapazitätswert C3 lässt $U_{BB}$ unter $1/2\ V_{DD}$ absinken. Der SENSE-Verstärker 33 gibt daher am Ausgang 34, sobald das Absinken von $U_{BB}$ erkannt wird, das dem Lagezustand 3 zugeordnete Signal A = OV ab. (Das Signal A kann bis zu diesem Zeitpunkt je nach dem Ergebnis des vorgängigen Lesezyklus auf $V_{DD}$ oder OV sein.) Das Signal A bleibt bis zum nächsten Lesezyklus 38' erhalten, sofern die Speisespannung $V_{DD}$ des Verstärkers nicht ausfällt. Im Lesezyklus 38' wird ein Speicherelement 1 mit der Membrane 2 im Lagezustand 4 ausgelesen. Der im Vergleich zu CD kleinere Kapazitätswert C4 lässt in der SENSE-Phase 40' $U_{BB}$ um $U_{BB}$ über $1/2\ V_{DD}$ ansteigen. Das Signal A wird auf $V_{DD}$ gelegt, sobald der SENSE-Verstärker 33 das Ansteigen von $U_{BB}$ erkennt.

Damit während des Lesezyklus 38 die Membrane 2 ihren Lagezustand 3, 4 nicht ändert, muss das Potential auf der BB-Leitung 24 unterhalb einer Ansprechschwelle für das Umschalten der Membrane 2 bleiben oder der Lesezyklus 38 muss kürzer als die Dauer einer Eigenschwingung der Membrane 2 sein.

2) In einer anderen Ausführungsform weist die Speicherzelle 13 (Figur 8) einen zusätzlichen, im Speicherelement 1 integrierten MOSFET 41 auf, dessen GATE-Elektrode durch einen Teil der Membrane 2 gebildet ist. Nur im Lagezustand 3, d. h. wenn die Membrane 2 unmittelbar über einem Leitungskanal 42 ist, erhöht ein z. B. positives Potential auf der Membrane 2 die Leitfähigkeit des MOSFET 41 zwischen Kontakten 43, 44. Vorteilhaft sind die Kontakte 43, 44 elektrisch unabhängig von den im Schreibzyklus 27 verwendeten Schaltkreisen und unmittelbar neben der Sperrschicht 9 in der Vertiefung 6 unter einer isolierenden Sperrschicht 9' auf dem Substrat 7 derart angelegt, dass ein seitlich vorstehender, in der halben Länge an der Membrane 2 angebrachter Flügel 45 als GATE-Elektrode des MOSFET 41 wirkt.

Der MOSFET 41 ist, wie alle MOSFET 41 weiterer Speicherzellen 13 mit dem Kontakt 43 über eine Leiterbahn 11 an eine gemeinsame SENSE-Leitung 46 und mit dem Kontakt 44 an eine gemeinsame FEED-Leitung 47 angeschlossen. Die SENSE-Leitung 46 ist z. B. über einen Leistungsverstärker ausserhalb des Bauelementes ablesbar. Der Lesezyklus 38 vereinfacht sich bei dieser Anordnung:

Die Metallschicht 12 und die FEED-Leitung 47 werden z. B. auf das gleiche Potential $V_{DD}$ gebracht. Falls die GATE-Elektrode bzw. die Membrane 2 im Lagezustand 3 ist, leitet der MOSFET 41 und bringt die SENSE-Leitung 46 auf $V_{DD}$. Ist die GATE-Elektrode im Lagezustand 4, reicht das elektrische Feld nicht aus,

6

den MOSFET 41 zum Leiten zu bringen, und die SENSE-Leitung bleibt auf dem Bezugspotential.

3) In einer anderen Ausführungsform ist die Metallschicht 12 als ein Permanentmagnet ausgebildet. Der Magnet betätigt im Lagezustand 3 einen der an sich bekannten Magnetfeldsensoren. Der Magnetfeldsensor setzt während des Lesezyklus den Lagezustand 3 bzw. 4 in ein elektronisches Signal um.

4) In einer weiteren Ausführungsform schliesst die Membrane 2 in einem der beiden Lagezustände 3 bzw. 4 einen elektrischen Kontakt zum elektrischen Auslesen des Lagezustandes 3 bzw. 4.

5) In einer weiteren Ausführungsform ist der MOSFET 41 in der Figur 8 durch einen optischen Sensor ersetzt. Nur im Lagezustand 3 berührt die Basisschicht 10' der Membrane 2 die lichtempfindliche Stelle des optischen Sensors, damit das durch die Basisschicht 10 von einer Lichtquelle auf dem Substrat 7 geleitete Licht an der optischen Kontaktstelle zwischen der Basisschicht 10' und dem optischen Sensor in den optischen Sensor eintritt. Der optische Sensor gibt daher je nach Lagezustand 3, 4 der Membrane 2 ein logisches, elektronisches Signal ab. In einer Abwandlung dieser Ausführung deckt die Membrane den Lichtsensor z. B. im Lagezustand 3 ab, damit seitlich einfallendes Licht den Lichtsensor nicht mehr erreichen kann, im Lagezustand 4 ist der Lichtsensor während des Lesezyklus durch eine Lichtquelle beleuchtet.

Diese Ausführungen können beispielsweise auch mikromechanische, optische Anzeigen nach Petersen direkt ansteuern, z. B. als unverlierbare direkt visuell ablesbare Anzeigen von elektronischen Messgeräten.

Speicherzellen 13 in den oben genannten Ausführungsformen können einzeln oder in grösserer Zahl auf einem Substrat 7 angeordnet sein. Die Speicherzellen 13 sind, wie an sich bei RAM, EEPROM usw. üblich, BIT-weise oder BYTE-weise organisiert und durch Adressleitungen ansteuerbar. In der Ausführungsform mit mikromechanischen Anzeigen kann die Organisation der Speicherzellen 13 durch die Anzeige z. B. als Punktmatrix bestimmt sein.

**Patentansprüche**

1. Speicher für digitale elektronische Signale mit mindestens einer Speicherzelle (13), die eine mindestens zweiseitig eingespannte, eine Vertiefung (6) auf der Oberfläche eines Substrates (7) überbrückende bistabile Membrane (2) mit einer Metallschicht (12) als mikromechanisches Speicherelement (1) enthält, die elektrisch zwischen zwei stabilen Lagezuständen (3; 4) umschaltbar ist, welche mechanische Spannungskräfte in der Membrane (2) festhalten,
   **dadurch gekennzeichnet,**
   daß eine elektrisch gut leitende Sperrschicht (9) in der Vertiefung (6), diese in der Tiefe begrenzend, in der Oberfläche des Substrates (7) angeordnet ist, daß jede Speicherzelle (13) elektronische Mittel zum Steuern elektrischer Ladungen in der Sperrschicht (9) und in der Metallschicht (12) der Membrane (2) aufweist, daß zum Umstellen der Membrane (2) die Richtung von Kräften zwischen den elektrischen Ladungen in der Sperrschicht (9) und in der Metallschicht (12) vorbestimmt vom angestrebten Lagezustand (3 bzw. 4) abhängig ist, daß die Membrane (2) durch die zwischen der Sperrschicht (9) und der Metallschicht (12) wirkenden Kräfte von einem Lagezustand (3 bzw. 4) in den anderen Lagezustand (4 bzw. 3) vorbestimmt umstellbar ist und daß Mittel zum Auslesen einer in der Speicherzelle (13) in Form des Lagezustands (3; 4) der Membrane (2) gespeicherten Information vorhanden sind.

2. Speicher nach Anspruch 1,
   **dadurch gekennzeichnet,**
   daß jede Speicherzelle (13) zwei MOSFETs (14; 15) zum Ansteuern der der Speicherzelle (13) zugeordneten Membran (2) aufweist.

3. Speicher nach Anspruch 2,
   **dadurch gekennzeichnet,**
   daß die MOSFETs (14; 15) mit einer WORD-Leitung (19), einer BIT BRIDGE-Leitung (24) und einer BIT FORCE-Leitung (25) verbunden sind, wobei beide Gates (16) der MOSFETs (14; 15) gemeinsam auf die WORD-Leitung (19) geführt sind und beide Substrate (18) der MOSFETs (14; 15) das gleiche Bezugspotential wie das Substrat (7) aufweisen, und daß mindestens während eines Schreibzyklus (27) die Metallschicht (12) durch den einen MOSFET (14) hindurch mit der BIT BRIDGE-Leitung (24) und die Sperrschicht (9) durch den anderen MOSFET (15) hindurch mit der BIT FORCE-Leitung (25) verbunden ist und Potentiale der BIT BRIDGE- und der BIT FORCE-Leitungen (24; 25) gegenüber dem Bezugspotential vorbestimmt vom zu erreichenden Lagezustand (3; 4) abhängig sind.

**4.** Speicher nach einem der vorhergehenden Ansprüche,
**dadurch gekennzeichnet,**
daß während eines Schreibzyklus (27) die elektrischen Ladungen in der Sperrschicht (9) und in der Metallschicht (12) zum Erzeugen von zwischen der Sperrschicht (9) und der Metallschicht (12) wirkenden Kräften mittels vorbestimmter elektrostatischer Felder angeordnet sind und daß zum Umschalten der Membrane (2) aus dem ersten Lagezustand (3) in den zweiten Lagezustand (4) die beiden Schichten (9; 12) ein gleiches Potential $(V_{SP})$ gegenüber dem Bezugspotential des Substrats (7) aufweisen bzw. daß zum Umschalten der Membrane (2) aus dem zweiten Lagezustand (4) in den ersten Lagezustand (3) nur auf der Metallschicht (12) das vom Bezugspotential verschiedene Potential $(V_{SP})$ vorhanden ist und die Sperrschicht (9) gleichzeitig auf dem Bezugspotential gehalten ist.

**5.** Speicher nach einem der Ansprüche 1 bis 3,
**dadurch gekennzeichnet,**
daß die elektronischen Mittel zum Steuern der in der Sperrschicht (9) und in der Metallschicht (12) fließenden Ladungen zum Erzeugen von zwischen den beiden Schichten wirkenden Kräften mittels vorbestimmter elektromagnetischer Felder eingerichtet sind, wobei die Sperrschicht (9) und die Metallschicht (12) zum Umschalten der Membrane (2) aus dem ersten Lagezustand (3) in den zweiten Lagezustand (4) parallel in den gleichen Richtungen (28 und 29) bewegte elektrische Ladungen und zum Umschalten der Membrane (2) aus dem zweiten Lagezustand (4) in den ersten Lagezustand (3) antiparallel in den Richtungen (29 und 30) bewegte elektrische Ladungen aufweisen.

**6.** Speicher nach einem der vorhergehenden Ansprüche,
**dadurch gekennzeichnet,**
daß über den Speicherzellen (13) in einem vorbestimmten Abstand zum Substrat (7) eine auf dem Bezugspotential gehaltene Abschirmung (17) angeordnet ist.

**7.** Speicher nach einem der vorhergehenden Ansprüche,
**dadurch gekennzeichnet,**
daß die Mittel zum Auslesen eine Auslesevorrichtung (26) und in jeder Speicherzelle (13) zwei MOSFETs (14; 15) umfassen, daß zum Auslesen während eines Lesezyklus (38; 38') die Sperrschicht (9) und die Metallschicht (12) durch beide MOSFETS (14; 15) der vorbestimmten Speicherzelle (13) hindurch mit der Auslesevorrichtung (26) verbunden sind, daß der Lesezyklus (38; 38') kürzer als eine Eigenschwingung der Membrane (2) gewählt ist und daß die Auslesevorrichtung (26) zum Vergleichen der Kapazität eines Meßkondensators (31) mit einem vom Lagezustand (3; 4) abhängigen Kapazitätswert eines von den beiden Schichten (9; 12) gebildeten Plattenkondensators (12') eingerichtet ist.

**8.** Speicher nach einem der Ansprüche 1 bis 6,
**dadurch gekennzeichnet,**
daß die Speicherzelle (13) als Mittel zum Auslesen einen zusätzlichen in der Vertiefung (6) des Speicherelements (1) unmittelbar neben der Sperrschicht (9) integrierten MOSFET (41) aufweist, dessen durch den Lagezustand (3; 4) der Membrane (2) und durch die Ladung auf der Membrane (2) bestimmte Leitfähigkeit zwischen einer SENSE-Leitung (46) und einer FEED-Leitung (47) meßbar ist, daß ein Teil (45) der Membrane (2) als eine mechanisch bewegbare GATE-Elektrode des MOSFET (41) ausgebildet ist und daß zum Auslesen während des Lesezyklus (38) die mechanisch bewegbare GATE-Elektrode des MOSFET (41) und die FEED-Leitung (47) auf dem gleichen Potential $(V_{DD})$ sind.

**9.** Speicher nach einem der Ansprüche 1 bis 6,
**dadurch gekennzeichnet,**
daß die Membrane (2) mindestens in einem der beiden Lagezustände (3; 4) einen elektrischen Kontakt als Mittel zum Auslesen schließt.

**10.** Speicher nach einem der Ansprüche 1 bis 6,
**dadurch gekennzeichnet,**
daß die Metallschicht (12) als Permanentmagnet ausgebildet ist und daß ein vom Permanentmagnet im ersten Lagezustand (3) betätigter Magnetfeldsensor vorhanden ist, der während des Lesezyklus den Lagezustand (3 bzw. 4) in ein elektronisches Signal umsetzt.

**11.** Speicher nach einem der Ansprüche 1 bis 6,

**dadurch gekennzeichnet,**
daß die Speicherzelle (13) als Mittel zum Auslesen einen in der Vertiefung (6) des Speicherelements (1) unmittelbar neben der Sperrschicht (9) integrierten optischen Sensor und eine als Lichtleiter ausgebildete Basisschicht (10') der Membrane (2) aufweist, daß nur im ersten Lagezustand (3) die Basisschicht (10') mit dem optischen Sensor eine optische Kontaktstelle bildet, wobei durch die Basisschicht (10') geleitetes Licht in den optischen Sensor eintritt, und daß der optische Sensor zum Erzeugen eines dem Lagezustand (3 bzw. 4) entsprechenden logischen elektronischen Signals eingerichtet ist.

12. Verfahren zum Herstellen eines Speichers nach einem der vorhergehenden Ansprüche, bei dem auf dem Substrat (7) eine Folge von Schichten, die Sperrschicht (9), eine schwachleitende p-Si-Schicht für die Stützer (5), eine Isolierschicht (10) und eine Basisschicht (10'), erzeugt wird,
**dadurch gekennzeichnet,**
daß wenigstens auf der Basisschicht (10') bei Temperaturen des Substrates (7) im Bereich des siedenden Stickstoffs die Metallschicht (12) in einer oder mehreren Schichten aufgebracht wird, worauf die Membrane (2) freigeätzt wird.

13. Verfahren nach Anspruch 12,
**dadurch gekennzeichnet,**
daß eine Metallschicht (12) mit einer Schichtdicke im Bereich von 0,02 bis 0,1 $\mu$m abgeschieden wird.

## Claims

1. A memory for digital electronic signals with at least one memory cell (13) including a bistable diaphragm (2) with a metal layer (12) as a micromechanical memory element (1), which is fixed at least on two sides and which bridges over a recess (6) on the surface of a substrate (7) and which can be electrically switched over between two stable positional conditions (3; 4) which mechanical stressing forces in the diaphragm (2) retain, characterised in that a barrier layer (9) which is a good conductor of electricity is arranged in the recess (6), defining same in respect of depth, in the surface of the substrate (7), that each memory cell (13) has electronic means for controlling electrical charges in the barrier layer (9) and in the metal layer (12) of the diaphragm, that for switching over of the diaphragm (2) the direction of forces between the electrical charges in the barrier layer (9) and in the metal layer (12) is dependent in a predetermined manner on the positional condition (3 or 4) aimed at, that the diaphragm (2) can be switched over in a predetermined manner from one positional condition (3 or 4) into the other positional condition (4 or 3 respectively) by the forces acting between the barrier layer (9) and the metal layer (12) and that there are bans for reading out an its of information stored in the memory cell (13) in the form of the positional condition (3; 4) of the diaphragm (2).

2. A memory according to claim 1 characterised in that each memory cell (13) has two MOSFETs (14; 15) for actuation of the diaphragm (2) associated with the memory cell (13).

3. A memory according to claim 2 characterised in that the MOSFETs (14; 15) are connected to a WORD-line (19), a BIT BRIDGE-line (24) and a BIT FORCE-line (25), wherein both gates (16) of the MOSFETs (14; 15) are jointly taken to the WORD-line (19) and both substrates (18) of the MOSFETs (14; 15) have the same reference potential as the substrate (7) and that at least during a writing cycle (27) the metal layer (12) is connected to the BIT BRIDGE-line (24) through the one MOSFET (14) and the barrier layer (9) to the BIT FORCE-line (25) through the other MOSFET (15) and potentials of the BIT BRIDGE- and the BIT FORCE-lines (24; 25) relative to the reference potential are dependent in a predetermined manner on the positional condition (3; 4) to be attained.

4. A memory according to one of the preceding claims characterised in that during a writing cycle (27) the electrical charges in the barrier layer (9) and in the metal layer (12) are arranged for the production of forces acting between the barrier layer (9) and the metal layer (12) by means of predetermined electrostatic fields and that for the purposes of switching over of the diaphragm (2) from the first positional condition, (3) into the second positional condition (4) the two layers (9; 12) have an equal potential ($V_{SP}$) relative to the reference potential of the substrate (7) or that for the purposes of switching over of the diaphragm (2) from the second positional condition (4) into the first positional condition (3) the potential ($V_{SP}$) which is different from the reference potential is present only on the metal layer (12) and the barrier layer (9) is simultaneously held at the reference potential.

5. A memory according to one of claims 1 to 3 characterised in that the electronic means for controlling the charges flowing in the barrier layer (9) and in the metal layer (12) are arranged for the production of forces acting between the two layers by means of predetermined electromagnetic fields, wherein the barrier layer (9) and the metal layer (12) have electrical charges which are moved in the same directions (28 and 29) in parallel for switching over of the diaphragm (2) from the first positional condition (3) into the second positional condition (4) and electrical charges which are moved in the directions (29 and 30) in anti-parallel relationship for the purposes of switching over of the diaphragm (2) from the second positional condition (4) into the first positional condition (3).

6. A memory according to one of the preceding claims characterised in that a screening means (17) which is held at the reference potential is arranged above the memory cells (13) at a predetermined spacing relative to the substrate (7).

7. A memory according to one of the preceding claims characterised in that the reading-out means include a reading-out device (26) and in each memory cell (13) two MOSFETs (14; 15), that for the reading-out operation during a reading cycle (38; 38') the barrier layer (9) and the metal layer (12) are connected to the reading-out device (26) through both MOSFETs (14; 15) of the predetermined memory cell (13), that the reading cycle (38; 38') is selected to be shorter than a natural oscillation of the diaphragm (2) and that the reading-out device (26) is arranged to compare the capacitance of a measuring capacitor (31) to a capacitance value, which is dependent on the positional condition (3; 4), of a plate capacitor (12') which is formed by the two layers (9; 12).

8. A memory according to one of claims 1 to 6 characterised in that as reading-out means the memory cell (13) has an additional MOSFET (41) which is integrated directly beside the barrier layer (9) in the recess (6) in the memory element (1) and whose conductivity, which is determined by the positional condition (3; 4) of the diaphragm (2) and by the charge on the diaphragm (2) can be measured between a SENSE-line (46) and a FEED-line (47), that a part (45) of the diaphragm (2) is in the form of a mechanically movable GATE-electrode of the MOSFET (41) and that for reading out during the reading cycle (38) the mechanically movable GATE-electrode of the MOSFET (41) and the FEED-line (47) are at the same potential ($V_{DD}$).

9. A memory according to one of claims 1 to 6 characterised in that the diaphragm (2) closes an electrical contact as the reading-out means at least in one of the two positional conditions (3; 4).

10. A memory according to one of claims 1 to 6 characterised in that the metal layer (12) is in the form of a permanent magnet and that there is a magnetic field sensor which is actuated by the permanent magnet in the first positional condition (3) and which converts the positional condition (3 or 4) into an electronic signal during the reading cycle.

11. A memory according to one of claims 1 to 6 characterised in that as reading-out means the memory cell (13) has an optical sensor which is integrated directly beside the barrier layer (9) in the recess (6) in the memory element (1), and a base layer (10'), which is in the form of a light guide, of the diaphragm (2), that the base layer (10') forms an optical contact location with the optical sensor only in the first positional condition (3), with light guided through the base layer (10') passing into the optical sensor, and that the optical sensor is arranged to produce a logic electronic signal corresponding to the positional condition (3 or 4).

12. A process for the production of a memory according to one of the preceding claims wherein a sequence of layers, the barrier layer (9), a weakly conducting P-Si-layer for the insulated supports (5), an insulating layer (10) and a base layer (10'), is produced on the substrate (7), characterised in that the metal layer (12) is applied in one or more layers at least on the base layer (10') with the substrate (7) at temperatures in the region of boiling nitrogen, whereupon the diaphragm (2) is etched free.

13. A process according to claim 12 characterised in that a metal layer (12) of a thickness in the range of from 0.02 to 0.1 $\mu$m is deposited.

EP 0 259 614 B1

**Revendications**

1.  Mémoire pour signaux électroniques numériques comportant au moins une cellule de mémorisation (13), qui contient une membrane bistable (2), maintenue au moins des deux côtés, recouvrant un creux (6) prévu dans la surface d'un substrat (7) et pourvue d'une couche métallique (12) servant d'élément de mémoire micromécanique (1), qui est commutable électriquement entre deux positions stables (3 ; 4), qui maintiennent des forces mécaniques de tension dans la membrane (2) , caractérisée en ce qu'une couche d'arrêt (9) électriquement bonne conductrice est disposée dans le creux (6) prévu dans la surface du substrat (7) en délimitant la profondeur dudit creux, en ce que chaque cellule de mémoire (13) comporte des moyens électroniques pour distribuer des charges électriques dans la couche d'arrêt (9) et dans la couche métallique (12) de la membrane (2), en ce que, pour une commutation de la membrane (2), la direction des forces entre les charges électriques dans la couche d'arrêt (9) et dans la couche métallique (12) est prédéterminée en fonction de la position stable envisagée (3 ou 4), en ce que la membrane (2) est commutable de façon prédéterminée par les forces s'exerçant entre la couche d'arrêt (9) et la couche métallique (12) depuis une position stable (3 ou 4) jusque dans l'autre position stable (4 ou 3) et en ce qu'il est prévu des moyens pour lire une information mémorisée dans la cellule de mémoire (13) sous la forme de la position stable (3 : 4) de la membrane (2).

2.  Mémoire selon la revendication 1, caractérisé en ce que chaque cellule de mémoire (13) comporte deux transistors MOSFET (14 ; 15) pour l'actionnement de la membrane (2) associée à la cellule de mémoire (13).

3.  Mémoire selon la revendication 2, caractérisé en ce que les transistors MOSFET (14 ; 15) sont reliés à un conducteur-WORD (19), à un conducteur BIT BRIDGE (24) et à un conducteur BIT FORCE (25), les deux grilles (16) des transistors MOSFET (14 ; 15) étant reliées en commun au conducteur-WORD (19) et les deux substrats (18) des transistors MOSFET (14 ; 15) présentant le même potentiel de référence que le substrat (7), et en ce que, au moins pendant un cycle d'écriture (27), la couche métallique (12) est reliée par l'un des transistors MOSFET (14) au conducteur-BIT BRIDGE (24) tandis que la couche d'arrêt (9) est reliée par l'autre transistor MOSFET (15) au conducteur-BIT FORCE (25), et les potentiels des conducteurs BIT BRIDGE (24) et BIT FORCE (25) sont prédéterminés par rapport au potentiel de référence en fonction de la position stable à atteindre (3 ; 4).

4.  Mémoire selon l'une des revendications précédentes, caractérisé en ce que, pendant un cycle d'écriture (27), les charges électriques dans la couche d'arrêt (9) et dans la couche métallique (12) sont réparties au moyen de champs électrostatiques prédéterminés pour produire des forces agissant entre la couche d'arrêt (9) et la couche métallique (12) et en ce que, pour une commutation de la membrane (2) de la première position stable (3) jusque dans la seconde position stable (4), les deux couches (9 ; 12) présentent un potentiel identique ($V_{SP}$) par rapport au potentiel de référence du substrat (7) ou bien en ce que, pour une commutation de la membrane (2) depuis la seconde position stable (4) jusque dans la première position stable (3), seulement le potentiel ($V_{SP}$) différent du potentiel de référence est appliqué à la couche métallique (12) tandis que la couche d'arrêt (9) est maintenue simultanément au potentiel de référence.

5.  Mémoire selon l'une des revendications 1 à 3, caractérisé en ce que les moyens électroniques pour la répartition des charges s'écoulant dans la couche d'arrêt (9) et dans la couche métallique (12) pour produire des forces agissant entre les deux couches sont activés à l'aide de champs électromagnétiques prédéterminés, la couche d'arrêt (9) et la couche métallique (12) étant soumises, pour une commutation de la membrane (2) de la première position stable (3) jusque dans la seconde position stable (4), à des charges électriques déplacées parallèlement dans les mêmes directions (28 et 29) tandis que, pour une commutation de la membrane (2) de la seconde position stable (4) jusque dans la première position stable (3), elles sont sollicitées par des charges électriques déplacées antiparallèlement dans des directions (29 et 30).

6.  Mémoire selon l'une des revendications précédentes, caractérisé en ce qu'il est prévu au-dessus des cellules de mémoire (13) un revêtement (17) maintenu au potentiel de référence et situé à une distance prédéterminée du substrat (7).

11

7. Mémoire selon l'une des revendications précédentes, caractérisé en ce que les moyens de lecture comprennent un dispositif de lecture (26) et, dans chaque cellule de mémoire (13) deux transistors MOSFET (14 ; 15), en ce que, pour une lecture pendant un cycle de lecture (38 ; 38'), la couche d'arrêt (9) et la couche métallique (12) sont reliées au dispositif de lecture (26) par l'intermédiaire des deux transistors MOSFET (14 ; 15) de la cellule de mémoire prédéterminée (13), en ce que le cycle de lecture (38 ; 38') est choisi plus court qu'une oscillation propre de la membrane (2) et en ce que le dispositif de lecture (26) est agencé pour une comparaison de la capacité d'un condensateur de mesure (31) avec une valeur de capacité, fonction de la position stable correspondante (3 ; 4), d'un condensateur à plaques (12') constitué par les deux couches (9 ; 12).

8. Mémoire selon l'une des revendications 1 à 6, caractérisé en ce que la cellule de mémoire (13) comporte, comme moyen de lecture, un transistor MOSFET intégré (41), disposé additionnellement dans le creux (6) de l'élément de mémoire (1) directement à côté de la couche d'arrêt (9) et dont la conductivité, déterminée par la position stable (3 ; 4) de la membrane (2) et par la charge existant sur la membrane (2), est mesurable entre un conducteur de détection (46) et un conducteur d'alimentation (47), en ce qu'une partie (45) de la membrane (2) est agencée comme une électrode de grille, mobile mécaniquement, du transistor MOSFET (41) et en ce que, pour une lecture pendant le cycle de lecture (38), l'électrode de grille, mobile Mécaniquement, du transistor MOSFET (41) et le conducteur d'alimentation (47) sont soumis au même potentiel (V$_{DD}$).

9. Mémoire selon l'une des revendications 1 à 6, caractérisé en ce que la membrane (2) produit, au moins dans une des deux positions stables (3 ; 4), la fermeture d'un contact électrique servant de moyen de lecture.

10. Mémoire selon l'une des revendications 1 à 6, caractérisé en ce que la couche métallique (12) est agencée comme un aimant permanent et en ce qu'il est prévu un détecteur de champ magnétique actionné par l'aimant permanent dans la première position stable (3) et qui convertit, pendant le cycle de lecture, la position stable (3 ou 4) en un signal électronique.

11. Mémoire selon l'une des revendications 1 à 6, caractérisé en ce que la cellule de mémoire (13) comprend, comme moyens de lecture, un détecteur optique intégré directement à côté de la couche d'arrêt (9) dans le creux (6) de l'élément de mémoire (1) ainsi qu'une couche de base (10'), agencée comme un conducteur de lumière, de la membrane (2), en ce que seulement dans la première position stable (3), la couche de base (10') forme avec le détecteur optique une zone optique de contact, la lumière transmise à travers la couche de base (10') pénétrant dans le détecteur optique, et en ce que le détecteur optique est agencé pour produire un signal électronique logique correspondant à la position stable (3 ou 4).

12. Procédé de fabrication d'une mémoire selon l'une des revendications précédentes, dans lequel sur le substrat (7) est formée une succession de couches constituées par la couche d'arrêt (9), une couche de Si-p faiblement conductrice pour le support (5), une couche isolante (10) et une couche de base (10'), procédé caractérisé en ce que la couche métallique (12) est déposée sous la forme d'une ou plusieurs couches au moins sur la couche de base (10') à des températures du substrat (7) de l'ordre de la température d'ébullition de l'azote et ensuite la membrane (2) est soumise à gravure.

13. Procédé selon la revendication 12, caractérisé en ce qu'une couche métallique (12) d'une épaisseur comprise entre 0,02 et 0,1 $\mu$m est formée.

# Fig. 1

# Fig. 2

# Fig. 3

# Fig. 4

# Fig. 5

Fig. 6

Fig. 7

Fig. 8